# EUROPEAN PATENT APPLICATION

(11) **EP 1 001 469 A2**
(43) Date of publication of application: **17.05.2000**
(21) Application number: 99124797.4
(22) Date of filing: 26.11.1996
(51) Int. Cl.: H01L 31/02, H01L 27/146

(54) **Forming contacts on semiconductor substrates for radiation detectors and imaging devices**

(30) Priority: 29.11.1995 GB 9524387
(62) Divisional of application: 96941641.1
(71) Applicant: SIMAGE OY, 02150 Espoo (FI)
(72) Inventor: Orava, Risto Olavi, 00730 Helsinki (FI); Pyyhtia, Jouni Ilari, 01360 Vantaa (FI); Schulman, Tom Gunnar, 02150 Espoo (FI); Sarakiinos, Miltiadis E., 1025 Geneva (CH); Spartiotis, Konstantinos E., 02150 Espoo (FI); Jalas, Panu, 00200 Helsinki (FI)
(74) Representative: Potter, Julian Mark

(57) **Abstract**

A method, suitable for forming metal contacts 31 on a semiconductor substrate 1 at positions for defining radiation detector cells, includes the steps of forming one or more layers of material 11,12 on a surface of the substrate with openings 23 to the substrate surface at the contact positions; forming a layer of metal 24 over the layer(s) of material and the openings; and removing metal at 28 overlying the layer(s) of material to separate individual contacts. Optionally, a passivation layer 11 to be left between individual contacts on the substrate surface, may be applied during the method. A method according to the invention prevents etchants used for removing unwanted gold (or other contact matter) coming into contact with the surface of the substrate (e.g. CdZnTe) and causing degradation of the resistive properties of that substrate. The product of the method and uses thereof are also described.

## Description

The invention relates to methods of manufacturing radiation detectors and radiation imaging devices, radiation detectors and imaging devices manufactured by these methods and the use of such imaging devices.

A typical method of manufacturing a radiation detector for an imaging device comprises applying a layer of a metal such as aluminium to both of the main surfaces of a planar semiconductor substrate, applying a layer of photoresistive material to cover the semiconductor material, exposing the photoresistive material on the surface of the planar substrate with an appropriate mask pattern, removing the photoresistive material to expose a pattern of the metal to be removed, etching away the metal to be removed and then removing the remaining photoresistive material to leave a pattern of contacts on one surface of the substrate and a metallised layer on the other surface of the substrate. The contacts on the first surface of the substrate then define an arrangement of radiation detector cells.

For optical wavelengths and charged radiation (β-rays), silicon has typically been used for the semiconductor material for the substrate. A method of the type described above has been used to good effect with this material.

In recent years, cadmium zinc telluride (CdZnTe) has increasingly been proposed as a more suitable semiconductor material for use in X-ray, γ-ray and to a lesser extent β-ray, radiation imaging. CdZnTe is good at absorbing X-rays and γ-rays giving better than 90% efficiency for 100 keV X-rays and γ-rays with a 2mm thick detector. The leakage or dark current of these detectors can be controlled and values of the order of 10 nA/cm² or less at 100 Volts bias are achievable.

A small number of companies worldwide currently produce these detectors commercially in a variety of sizes and thicknesses. Usually one or both sides of the planar detectors are contacted with a continuous metal layer such as gold (Au) or platinum (Pt). As mentioned above, such detector substrates then need to be processed to produce a detector having a pattern of contacts (e.g. pixel pads) on one surface, with the opposite surface remaining uniformly metallized, in order that the detector may be position sensitive, that is in order that the detector is able to produce a detector output indicating the position at which radiation impacts the detector. A readout chip then can be 'flip-chip' joined to the patterned side of the CdZnTe detector (e.g., by bump bonding using balls of indium or conductive polymer material, gluing using one-way conductive materials or other conductive adhesive layer techniques) so that the position dependent electrical signals which result from incidence and absorption in the detector cells of X-rays or γ-rays can be processed. The readout chip could be of the pulse counting type with very fast integration and processing time (typical a few microseconds or at most a few milliseconds). Alternatively, it may be one of type described in the Applicant's copending International patent application PCT/EP 95/02056 which provides for charge accumulation for individual detector cells. With an imaging device as described in PCT/EP 95/02056, integration times can be several milliseconds, or tens or hundreds of milliseconds. As the signal integration or standby/readout period increases it becomes more critical that the gold or platinum contacts on the CdZnTe surface are electrically separated to a high degree to avoid signals from neighbouring contacts (pixel pads) leaking and causing the contrast resolution to degrade.

It has been found that the traditional method of forming the contacts on the detector surface, particularly when CdZnTe is used as the semiconductor material, does not provide as high an electrical separation of the contacts would be desired to make optimum use of the advantages which are to be derived from the imaging devices as described in the International application PCT/EP 95/02056, which is incorporated herein by reference.

In accordance with one aspect of the invention, there is provided a method of manufacturing a radiation detector, having metal contact structures on a semiconductor substrate at spaced positions for defining radiation detector cells, wherein the method includes steps of:
a) forming one or more layers of material on a surface of the substrate with openings to the substrate surface at the contact positions;
b) forming a layer of metal over the layer(s) of material and the openings; and
c) removing metal overlying the layer(s) of material to separate individual contacts.

The present inventors have found that the surface resistivity of a CdZnTe semiconductor substrate is degraded when the substrate is exposed to metal etchants suitable for removing gold and/or platinum. As a result of this, the electrical separation of the individual contacts which result from the conventional method of forming such contacts is not as good as would be expected from the properties of that material before treatment. By using a method in accordance with the invention, the surface of the semiconductor substrate between the contacts can he isolated from the metal etchants, thus preventing the damage which would result if the metal etchants came into contact with the semiconductor surface.

In one method in accordance with the invention, step (a) includes:
a(i) forming a layer of photoresistive material on the substrate surface;
a(ii) selectively exposing the photoresistive material and removing photoresistive material from areas corresponding to the contact positions to expose the substrate surface.

In another method in accordance with the invention, step (a) includes:
a(i) forming a layer of passivation material on the substrate surface;
a(ii) forming a layer of photoresistive material on the passivation layer;
a(iii) selectively exposing the photoresistive material and removing the photoresistive material from areas corresponding to the contact positions to expose the passivation material layer; and
a(iv) removing the passivation material from the areas exposed in step a(iii) corresponding to the contact positions to expose the substrate surface.

The use of an insulating layer of passivation material means that after manufacture of the detector, the passivation material remains between the contacts protecting the semiconductor surface from environmental damage in use and further enhancing the electrical separation of the contacts.

To protect the other main surface and the sides (edges) of the semiconductor substrate, photoresistive material can additionally be applied to all exposed surfaces prior to step a(iv).

In a preferred method in accordance with the invention, step (c) includes:
c(i) forming a further layer of photoresistive material on at least the metal layer;
c(ii) selectively exposing the photoresistive material of the further layer and removing the photoresistive material of the further layer apart from areas corresponding generally to the openings; and
c(iii) removing metal not covered by the photoresistive material of the further layer.
   A further step, after step c(iii), can include:
c(iv) removing remaining photoresistive material.

In a preferred method in accordance with the invention, the areas corresponding generally to the openings are larger than the corresponding openings, so that after the removal in step c(iii) of the metal not covered by the photoresistive material of the further layer, the contacts cover the opening and also extend up and laterally beyond the opening. In this way the ingress of metal etchant around the photoresistive material, whereby the metal etchant might reach the semiconductor surface, can be avoided.

The invention finds particular, but not exclusive use with substrates formed of cadmium zinc telluride (CdZnTe). It will be appreciated that the method of the invention can be used with other substrate materials as well.

Preferably, the metal layer for forming the contacts is applied by a method such as sputtering, evaporation or electrolytic deposition, preferably by sputtering.

Preferably, the metal layer for forming the contacts comprises gold (Au), although other metals, for example platinum (Pt) or indium (In), could also be used.

Preferably, the passivation layer is formed of aluminum nitride (AlN).

Step (c) can comprise removing unwanted metal by a photoresist liftoff technique, although more typically step (c) comprises removing unwanted metal by means of an appropriate metal etchant.

Each metal contact can define a respective pixel cell of an array of pixel cells, or one of a plurality of strips arranged parallel to each other, depending on the application of the detector.

With a method according to the invention, the metal contacts can be of the order of 10µm across with a spacing of the order of 5µm.

The invention also provides a method of manufacturing a radiation detector comprising a semiconductor substrate with a plurality of metal contacts for respective radiation detector cells on a first surface thereof and layer of metallisation on a surface of the substrate opposite to the first surface, the metal contacts being formed on the first surface by a method as described above. The layer of metallisation can be formed on the opposite surface of the substrate prior to step (a) of the method described above.

The invention further provides a method of manufacturing a radiation imaging device comprising:
manufacturing a radiation detector as defined above; and
individually connecting individual contacts for respective detector cells to corresponding circuits on a readout chip, for example by a flip-chip technique.

In accordance with another aspect of the invention, there is provided a radiation detector comprising a semiconductor substrate with a plurality of metal contacts for respective radiation detector cells on a first surface thereof and layer of metallisation on a surface of the substrate opposite to the first surface, wherein the overall width of the metal contacts is larger than the width of the contact adjacent the substrate.

In a preferred embodiment of the invention the semiconductor substrate is made of cadmium zinc telluride (CdZnTe), although other semiconductor substrate materials, for example cadmium telluride (CdTe), could be used. Preferably also passivation material is provided between individual contacts. Aluminium nitride has been found to be particularly effective as a passivation material for CdZnTe because it can be applied at low temperature, CdZnTe being temperature sensitive.

The invention also provides a radiation detector comprising a semiconductor substrate with a plurality of metal contacts for respective radiation detector cells on a first surface thereof and a layer of passivation material on the surface between the metal contacts, the passivation material comprising aluminium nitride.

The metal contacts can define an array of pixel cells, or a plurality of strips arranged parallel to each other, depending on the field of use of the detector.

Pixel contacts formed on detector substrate are preferably substantially circular and are arranged in a plurality of rows, more preferably with alternate rows preferably being offset from adjacent rows.

The metal contacts are of the order of 10µm across with a spacing of the order of 5µm.

In detectors in accordance with the invention, the resistivity between metal contacts should be in excess of 1GΩ/square, more preferably in excess of 100GΩ/square and even more preferably in excess of 1000GΩ/square (1TΩ/square).

The invention also provides a radiation imaging device comprising a radiation detector as defined above and a readout chip having circuits for accumulating charge from successive radiation hits, individual contacts for respective detector cells being connected by a flip-chip technique to respective circuits for accumulating charge.

A radiation imaging device in accordance with the invention finds particular application for X-ray, γ-ray and β-ray imaging.

Thus, an embodiment of the invention can provide a method for manufacturing, for example, detectors having a CdZnTe substrate with one side uniformly metallised with gold and the other side patterned with gold structures in a manner that does not adversely affect the surface characteristics of the CdZnTe substrate between the gold structures. Thus, a method can be provided for creating gold structures on one side of a CdZnTe detector, the method achieving inter-structure resistivity of the order of GΩ/square or tens or hundreds of GΩ/square.

The use of an electrically insulating passivation layer between contacts further enables the area between metal contacts to be protected, thus giving the detector stable performance over time and avoiding effects such as oxidation which increase the surface leakage current and decrease the inter-contact resistivity. Aluminium nitride (AlN) passivation has been found to be particularly effective when applied between gold contacts to protect the surface and enhance the electrical separation of the gold contacts. The passivation layer of aluminium nitride can be implemented at relatively low temperatures typically less than 100°C. By contrast, silicon oxide (SiO₂), which is typically used as a passivant for silicon (Si) semiconductors, needs temperatures in excess of 200°C. After exposure to these temperatures, CdZnTe would be unusable.

Embodiments and of the invention will be described hereinafter, by way of example only, with reference to the accompanying drawings in which:
Figure 1 is an example of a first method of forming metal contacts on a semiconductor substrate;
Figure 2 is an example of a method of forming metal contacts on a semiconductor substrate with a passivation layer between contacts;
Figure 3 is another example of a method of forming metal contacts on a semiconductor substrate with a passivation layer between contacts;
Figure 4 is a schematic plan view of one contact configuration on a detector substrate;
Figure 5 is a schematic plan view of another contact configuration on a detector substrate; and
Figure 6 is a schematic plan view of a further contact configuration on a detector substrate.

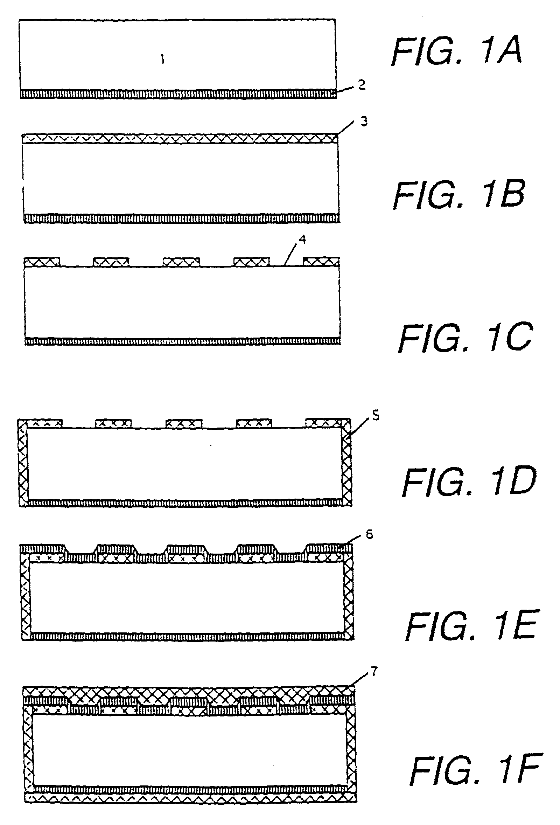

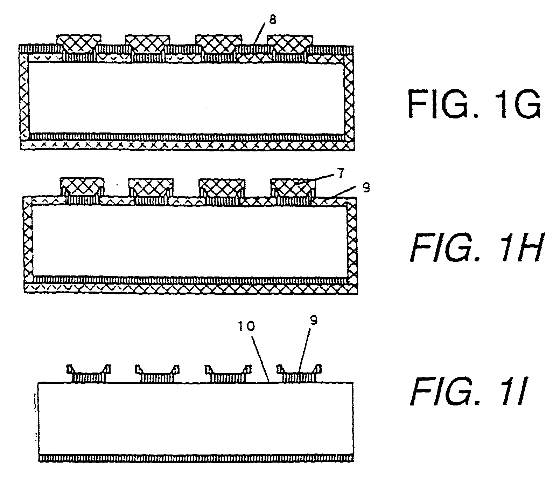

Figure 1 illustrates one example of a method in accordance with the invention of forming metal contacts on a semiconductor substrate at positions for defining radiation detector cells. In this example it is assumed that the semiconductor substrate is made of cadmium zinc telluride (CdZnTe), although it will be appreciated that other semiconductor materials, for example cadmium telluride (CdTe), can be used. Also, it will be assumed that the metal used for the metallisation layer and the gold contacts is gold, although it will be appreciated that other metals, alloys or other conductive materials, for example platinum or indium, could be used.

Thus, Figure 1 is a schematic cross-sectional view from the side of a detector substrate at various stages in the formation of gold contacts on a CdZnTe substrate.
- Step A:: The CdZnTe detector substrate 1 has one face (the lower face in Figure 1) uniformly metallised with gold 2.
- Step B:: Photoresistive material (photoresist) 3 is spun on the bare face (the upper face in Figure 1) of the CdZnTe substrate. The photoresist is any of the common materials used in photolithography, sensitive to certain light wavelengths for creating a pattern on it.
- Step C:: Openings 4 are made in the photoresist using an appropriate mask or other conventional technique for removing photoresist according to a desired pattern.
- Step D:: Photoresist is also applied to the sides 5 of the detector to protect them from consequent steps.
- Step E:: Gold 6 is sputtered, evaporated or laid by electrolysis uniformly over the photoresist and the openings on the upper side of the detector, as a result of which the gold layer 6 covers the photoresist and also contacts the CdZnTe surface at the openings of the photoresist. The upper gold surface and the uniformly metallized face 2 are electrically separated by the photoresist 5 on the sides (edges) of the detector.
- Step F:: A second layer 7 of photoresist is applied over the gold layer 6 and also over the uniformly metallized face 2.
- Step G:: Openings 8 are made in the second layer 7 of photoresist corresponding to the gold areas that need to be removed, that is the gold areas 8 not in contact with the CdZnTe surface. It will be noted that each area of photoresist which remains on the upper face is larger than the corresponding area of gold in contact with the CdZnTe substrate.
- Step H:: The unnecessary gold areas 8 are etched away using a gold etchant via the openings in the second layer 7 of photoresist. The second layer of photoresist 7 protects the gold patterns 9 which are in contact with the CdZnTe surface, since the photoresist is not sensitive to the etchant. As the area of photoresist which remains on the upper face is larger than the corresponding area of gold in contact with the CdZnTe substrate, this prevents the etchant reaching the CdZnTe substrate, even at the interface between the gold and the first layer of photoresist 3.
- Step I:: The second layer 7 of photoresist is removed thus revealing the gold contacts 9 and the first layer 3 of photoresist is removed thus revealing the bare face 10 of the CdZnTe detector between the contacts 9. The photoresist layer 5 on the sides of the detector and lower face of the detector is also removed at this stage. No photoresist therefore remains on the CdZnTe detector since it is usually hydroscopic material that in time would absorb humidity and degrade the detector performance.

As an alternative to using steps F-I above, the first layer of photoresist 3 may be removed with the unwanted gold using a technique known as 'liftoff'. In this case the unwanted gold is removed without involving a second layer of photoresist and without using a gold etchant.

Consequently, with the above procedure the end result is a CdZnTe detector with the lower face 2 uniformly metallised with gold and the upper face metallized with gold 9 in a desired pattern. The method ensures that at no stage the gold etchant comes in contact with the CdZnTe surface. The area 10 between the final gold patterns (pixel pads) 9 thus remains totally unharmed and is not influenced by the gold etchant. As a result, the surface of the CdZnTe retains very high resistivity, in excess of 1GΩ/square between gold pixel pads 9, and very low surface leakage current. As mentioned above, as high as possible resistivity between gold pixel pads 9 is desired in order to allow long integration, standby or readout times of the signal created from impinging X-rays and γ-rays without deterioration of the image contrast resolution. With the above method, the inter-pixel resistivity can be tens, hundreds or even few thousands of GΩ/square without compromising pixel resolution. Indeed 300GΩ/square has been measured and values in excess of a TΩ/square are achievable.

With the above described method gold pixel pads 9 as small as 10µm across with 5µm spacing in between (i.e. 15µm position sensitivity) can be readily obtained, while retaining very high inter pixel resistivity.

Additionally, a passivation layer can be applied between the gold pixel pads. Passivation will ensure a stable performance over time, by avoiding oxidation of the surface not covered by gold. Passivation also enhances the inter-pixel resistivity. One problem is the compatibility of the passivation layer with respect to CdZnTe. The inventors have found that aluminium nitride is an appropriate passivation material for CdZnTe.

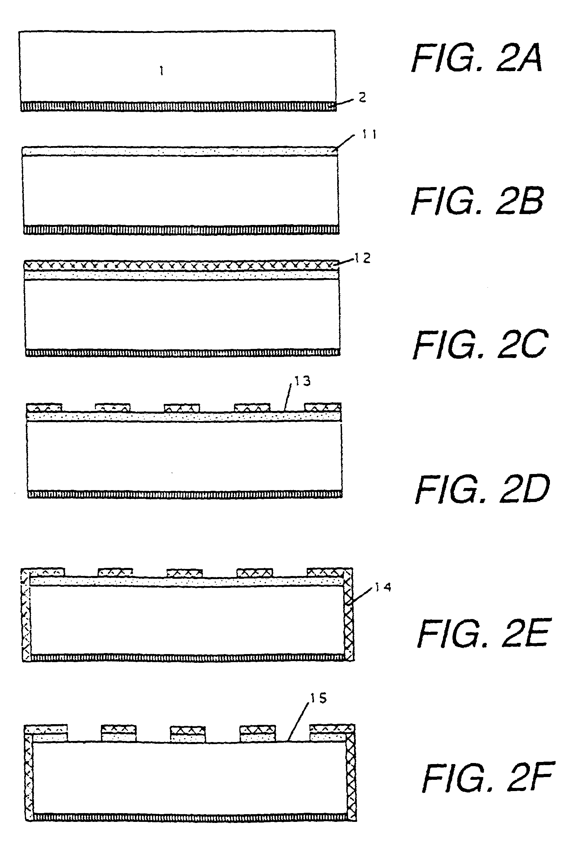

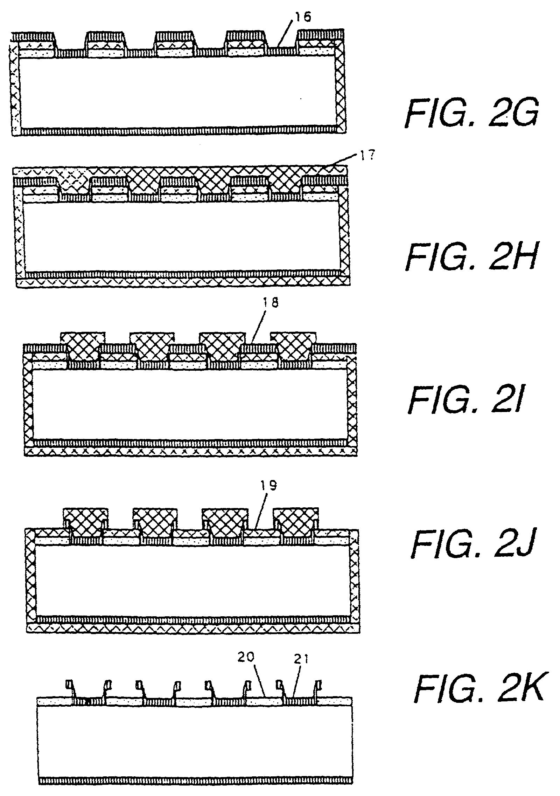

Figure 2 illustrates a method of forming metal contacts on a semiconductor substrate at positions for defining radiation detector cells with a layer of passivation material between the metal contacts. The same assumptions are made as for the method of Figure 1. In addition, it is assumed that the passivation material is aluminium nitride, although other materials could be used where compatibility with the substrate material is given.
- Step A:: The CdZnTe detector substrate 1 has one face (the lower face in Figure 1) uniformly metallised with gold 2.
- Step B:: Aluminium nitride 11 is sputtered on the bare face of the CdZnTe detector 1.
- Step C:: Photoresistive material (photoresist) 12 is spun on the passivation layer 11.
- Step D:: Openings 13 are made in the photoresist 12 using an appropriate mask for removing photoresist according to a desired pattern.
- Step E:: Photoresist is also applied to the sides 14 of the detector to protect them from consequent steps.
- Step F:: Openings 15 are made though the passivation layer 11 using an aluminium nitride etchant to expose the CdZnTe substrate.
- Step G:: Gold 16 is sputtered, evaporated or laid by electrolysis uniformly over the photoresist and the openings on the upper side of the detector, as a result of which the gold layer 16 covers the photoresist and also contacts the CdZnTe surface at the openings of the photoresist. The upper gold surface and the uniformly metallized face 2 are electrically separated by the photoresist 14 on the sides of the detector.
- Step H:: A second layer 17 of photoresist is applied over the gold layer 16 and also over the uniformly metallized face 2.
- Step I:: Openings 18 are made in the second layer 17 of photoresist corresponding to the gold areas that need to be removed, that is the gold areas at 18 not in contact with the CdZnTe surface. It will be noted that each area of photoresist which remains on the upper face is larger than the corresponding area of gold in contact with the CdZnTe substrate.
- Step J:: The unnecessary gold areas 19 are etched away using a gold etchant via the openings 18 in the second layer 17 of photoresist. The second layer of photoresist 17 protects the gold patterns 20 which are in contact with the CdZnTe surface, since the photoresist is not sensitive to the etchant. As the area of photoresist which remains on the upper face is larger than the corresponding area of gold in contact with the CdZnTe substrate, this prevents the etchant reaching the CdZnTe substrate, even at the interface between the gold and the first layer of photoresist 3.
- Step K:: The second layer 17 of photoresist is removed thus revealing the gold contacts 21 and the first layer 12 of photoresist is removed thus revealing the passivation layer 11 in the regions 20 between the contacts 21. The photoresist layer on the sides of the detector and lower face of the detector is also removed at this stage. No photoresist therefore remains on the CdZnTe detector since it is usually hydroscopic material that in time would absorb humidity and deteriorate the detector performance.

Once again, at no step does the gold etchant, or indeed the aluminium nitride etchant come in contact with the regions 20 between the gold pixel contacts 21 or the edges and sides of the CdZnTe detector. As a consequence, during the above procedure the surface of the substrate at 20 between the gold contacts 21 remains unharmed, retaining very high resistivity of the order of GΩ/square, tens, hundreds or even thousands of GΩ/square. The aluminium nitride passivation covers the area 20 between the metal contacts 21 protecting the corresponding regions form oxidation (providing stability over time) and enhancing the inter-contact resistivity.

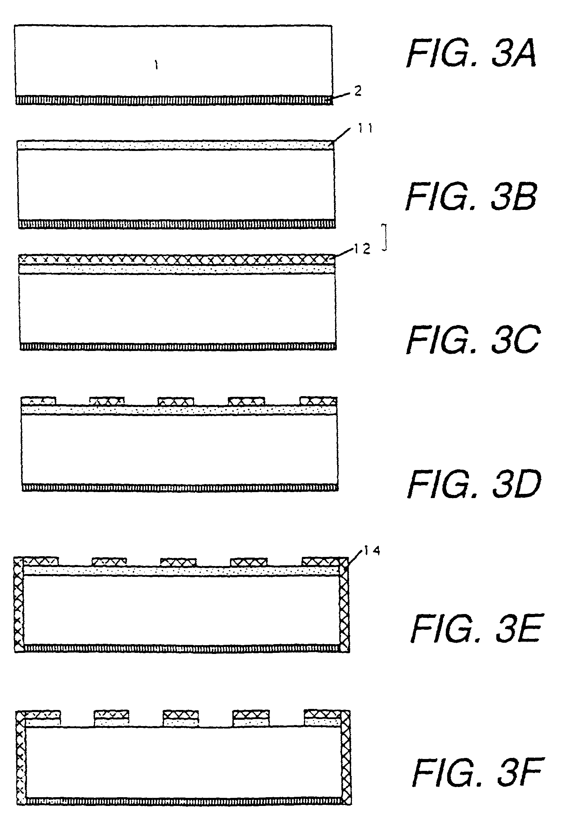

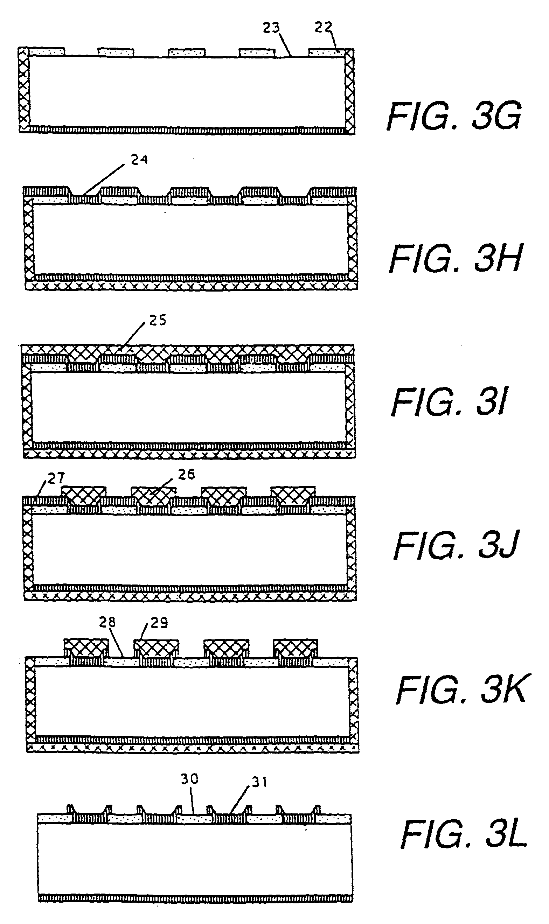

Variations of the above procedure may be applied without departing from the scope of the invention. For example the first layer 12 of photoresist may be removed prior to gold sputtering (after openings 15 have been made). This alternative method is shown in Figure 3. In the method shown in Figure 3, steps A - F correspond to steps A - F of the method of Figure 2.
- Step G:: This is an additional step in which the photoresist is removed from the upper face to expose the passivation layer at 22.
- Step H:: This corresponds generally to step G of Figure 2 except that in step H the gold is applied over the passivation layer at 22 and the openings at 23 (see Figure 3G).
- Steps I - L: correspond generally to steps H - K, respectively, of Figure 2, except for the absence of the layer of photoresist 12.

A result of the method of Figure 3 is that the resultant pixel pads are flatter (i.e. they have a lower profile) than with the method of Figure 2, as can be seen by comparing Figures 2K and 3L.

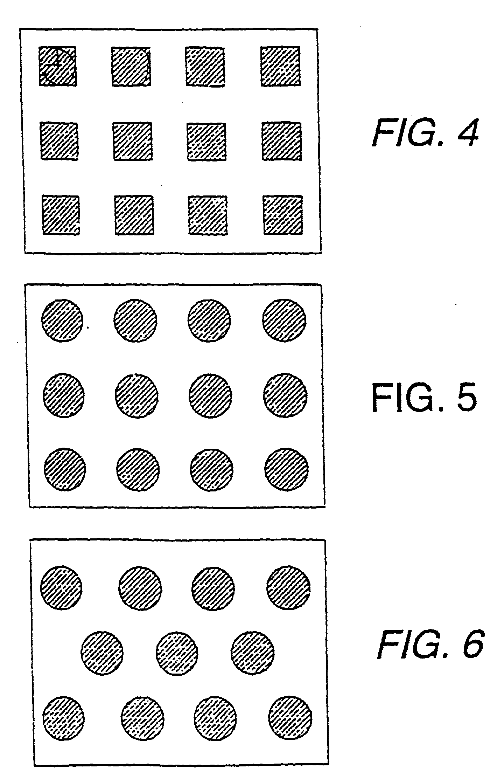

Figures 4, 5 and 6 are used to illustrate possible pixel contact patterns on the upper surface of the detector substrate. In Figure 4, an array of square pixel contact pads is shown. In Figure 5 an array of circular pixel pads is shown. The use of circular rather than square pixel pads increases the surface resistance between pads by increasing the amount of resistive material between adjacent pads. Figure 6 illustrates an array of offset (honeycombed) pixel pads. Once again this further increases the resistance between pads by increasing the surface amount of resistive material between adjacent pads.

It will be appreciated that rather than providing an array of contacts for defining an array of pixel detector cells, other contact configurations, for example contact strips for defining strip-shaped detector cells, can be obtained with the same method.

Although reference has been made to the use of gold for the contacts, gold is an advantageous material because it can be readily etched to define the desired contact structures and give good contact (better than aluminium, for example) to the CdZnTe, it is apparent that the procedure disclosed above could also be applied for any kind of metal contacts (e.g. platinum) in combination with an appropriate etchant.

As mentioned above, it should be noted that the longitudinal dimensions (width) of the top of the gold contacts 9 (Figure 1), 21 (Figure 2) or 32 (Figure 3) is larger than that at the gold-substrate interface. This arises from the relative sizes of the openings to the substrate surface and the photoresist left over the portions for forming the contacts to ensure that, when redundant gold is etched away, the etchant will not seep through to the interface between first layer of photoresist (or the passivation layer) and gold in the openings.

A radiation imaging device can be constructed by connecting a radiation detector produced by the method according to one of the above described methods to a readout chip having circuits for accumulating charge from successive radiation hits, individual contacts (e.g. pixel pads) for respective detector cells being 'flip-chip' joined (e.g., by bump bonding using balls of indium or conductive polymer material, gluing using one-way conductive materials, or other conductive adhesive layer techniques) to respective circuits for accumulating charge.

Thus, the invention teaches how to obtain a radiation detector (e.g. based on a CdZnTe substrate) with one side metallised according to a desired pattern with maximum possible electrical resistivity separation between the metal contacts. High resistivity between metal contacts is desirable to improve contrast resolution and eliminate signal leakage between adjacent metal contacts on the substrate surface. This is particularly relevant when long charge accumulation times and long standby/readout times are employed by the readout chip. Such accumulation and standby/readout times could, for example, be in excess of 1msec in examples of imaging devices using a radiation detector manufactured in accordance with the present invention. Such imaging devices find application, for example, for X-ray, γ-ray and β-ray imaging as described in the applicant's International patent application PCT/EP 95/02056 incorporated herein by reference.

Although particular embodiments of the invention have been described by way of example, it will be appreciated that additions, modifications and alternatives thereto may be envisaged.

## Claims

1. A radiation detector comprising a semiconductor substrate for detecting radiation with a plurality of metal contacts for respective radiation detector cells on a first surface thereof and with a layer of conductive material on a second surface of said substrate opposite to said first surface, wherein said substrate is formed from cadmium zinc telluride or cadmium telluride semiconductor material for detecting X-rays, γ-rays or β-rays, said cell contacts and said layer of conductive material are on said first and second surfaces, respectively, of said semiconductor material and passivation material extends between individual contacts on said first surface of said substrate.

2. A radiation detector according to Claim 1, wherein said metal contacts define an array of pixel cells.

3. A radiation detector according to Claim 2, wherein said contacts are substantially circular and are arranged in a plurality of rows, with alternate rows preferably being offset from adjacent rows.

4. A radiation detector according to Claim 2, wherein said metal contacts define a plurality of strips arranged parallel to each other.

5. A radiation detector according to any preceding Claim, wherein said metal contacts are of the order of 10µm across with a spacing of the order of 5µm.

6. A radiation detector according to any preceding Claim, wherein said semiconductor substrate is cadmium zinc telluride.

7. A radiation detector according to any preceding Claim, wherein the resistivity between metal contacts is in excess of 1GΩ/square, preferably in excess of 10GΩ/square, more preferably in excess of 100GΩ/square and even more preferably in excess of 1000GΩ/square (1TΩ/square).

8. A radiation detector according to any preceding Claim, wherein a said metal contact comprises a rim upstanding from said first substrate surface.

9. A radiation detector according to any preceding claim, wherein said passivation material comprises aluminium nitride.

10. A radiation imaging device comprising a radiation detector in accordance with any preceding Claim, and a readout chip having a circuit for accumulating charge from successive radiation hits, individual contacts for respective detector cells being connected by a flip-chip technique to respective circuits for accumulating charge.

11. Use of a radiation imaging device according to Claim 10, for X-ray, γ-ray and β-ray imaging.

12. A method of manufacturing a radiation detector having a plurality of detector cell contacts on a first surface of a semiconductor radiation detector substrate at positions for defining radiation detector cells and a layer of conductive material on a second surface of said substrate opposite to said first surface, said substrate being formed from cadmium zinc telluride or cadmium telluride semiconductor material for detecting X-rays, γ-rays or β-rays, and said cell contacts and said layer of conductive material being on said first and second surfaces, respectively of said semiconductor material, wherein said method includes steps of forming said contacts on said first surface including steps of:
a) forming a layer of passivation material on said first surface of said substrate with openings to said substrate surface at said contact positions;
b) applying metal over said layer and said openings; and
c) removing metal overlying said layer to separate individual detector cell contacts.

13. A method according to Claim 12, said step a) comprising the substeps of:
a(i) forming a layer of passivation material on said first substrate surface;
a(ii) forming a layer of photoresistive material on said passivation layer;
a(iii) selectively exposing said photoresistive material;
a(iv) removing said photoresistive material from areas corresponding to said contact positions to expose said first substrate surface; and
a(v) removing said passivation material from said areas exposed in step a(iv) corresponding to said contact positions to expose said first substrate surface.

14. A method according to Claim 12 or 13, said step c), comprising substeps of:
c(i) forming a further layer of photoresistive material on at least said metal;
c(ii) selectively exposing said photoresistive material of said further layer apart from areas corresponding generally to said openings;
c(iii) removing metal not covered by said photoresistive material of said further layer; and
c(iv) removing remaining photoresistive material.

15. A method according to Claim 14 dependent on Claim 13, wherein step (a) additionally includes, after step a(v):
a(vi) removing remaining photoresistive material of said photoresistive material layer.

16. A method according to Claim 14 or 15, wherein said areas corresponding generally to said openings are larger than the corresponding openings, so that after removal in step c(iii) of metal not covered by said photoresistive material of said further layer, said contacts cover said opening and also extend up and laterally beyond said opening.

17. A method according to any one of Claims 12 to 16, wherein said metal for forming said contacts is applied by sputtering, evaporation or electrolytic deposition.

18. A method according to Claim 7, wherein said metal for forming said contacts comprises gold, platinum or indium.

19. A method according to any one of Claims 12 to 18 dependent on Claim 3, wherein step (c)(iii) comprises removing unwanted metal by means of an appropriate metal etchant.

20. A method according to any one of Claims 12 to 19, wherein each metal contact defines a respective pixel cell of an array of pixel cells.

21. A method according to any of Claims 12 to 19, wherein each metal contact defines one of a plurality of strips arranged parallel to each other.

22. A method according to Claim 20 or 21, wherein said metal contacts are of the order of 10µm across with a spacing of the order of 5µm.

23. A method according to any one of Claims 12 to 22, including, prior to step (a), a step of forming said layer of conductive material on said second surface of said substrate.

24. A method of manufacturing a radiation imaging device comprising:
manufacturing a radiation detector in accordance with any one of Claims 12 to 23; and
individually connecting individual detector cell contacts for respective detector cells to corresponding circuits on a readout chip by a flip-chip technique.

25. A method according to any one of claims 12 to 24, wherein said passivation material comprises aluminium nitride.
